# EUROPÄISCHE PATENTSCHRIFT

(11) **EP 1 887 698 B1**
(45) Veröffentlichungstag und Bekanntmachung des Hinweises auf die Patenterteilung: **11.04.2012**
(21) Anmeldenummer: 07013423.4
(22) Anmeldetag: 10.07.2007
(51) Int. Cl.: H03K 17/0814, H03K 17/687, H03K 17/10, H03K 19/0175

(54) **Levelshifter für eine Ansteuerschaltung für Leistungshalbleiterbauelemente**
Level shifter for an actuator switch for power semiconductor components
Modificateur de niveau pour un commutateur de commande pour composants semi-conducteurs de puissance

(30) Priorität: 10.08.2006 DE 102006037336
(43) Veröffentlichungstag der Anmeldung: 13.02.2008
(73) Patentinhaber: SEMIKRON Elektronik GmbH & Co. KG, 90431 Nürnberg (DE)
(72) Erfinder: Herzer, Reinhard, Dr., 98693 Ilmenau (DE); Rossberg, Matthias, 98693 Ilmenau (DE); Vogler, Bastian, 98693 Ilmenau (DE)

(56) Entgegenhaltungen:
- EP-A- 0 453 376
- DE-A1- 10 152 930
- MARVIN VAN DER KOOI ET AL: "MOS moves into higher- power applications" ELECTRONICS, Bd. 49, Nr. 13, 24. Juni 1976 (1976-06-24), Seiten 98-103, XP002531713
- SERNEELS B ET AL: "7.8 - A High-Voltage Output Driver in a Standard 2.5V 0.25/spl mu/m CMOS Technology" 15. Februar 2004 (2004-02-15), SOLID-STATE CIRCUITS CONFERENCE, 2004. DIGEST OF TECHNICAL PAPERS. ISSCC. 2004 IEEE INTERNATIONAL, IEEE, PISCATAWAY, NJ, USA, PAGE(S) 146 - 155 , XP010722195 ISBN: 978-0-7803-8267-1 * Seite 1, linke Spalte, letzter Absatz - rechte Spalte, Zeile 25; Abbildung 7.8.2. *

## Beschreibung

Die Erfindung beschreibt einen Levelshifter vorzugsweise für einer Ansteuerschaltung die in leistungselektronischen Systemen benötigt wird um Leistungshalbleiterschalter anzusteuern, die als Einzeischalter oder in einer Brückenschaltung angeordnet sind. Derartige Brückenschaltungen sind als Ein-, Zwei-, oder Dreiphasen-Brückenschaltungen bekannt, wobei die einphasige sog. Halbbrücke einen Grundbaustein leistungselektronischer Schaltungen darstellt. In einer Halbbrückenschaltung sind zwei Leistungsschalter, ein erster sog. TOP-Schalter und ein zweiter sog. BOT-Schalter in einer Reihenschaltung angeordnet.

Eine derartige Halbbrücke weist in der Regel eine Verbindung zu einem Gleichstromzwischenkreis auf. Der Ausgang, typischerweise der Wechselspannungsanschluss der Halbbrücke ist meist mit einer Last verbunden. Die Ansteuerschaltung besteht in der Regel aus mehreren Teilschaltungen bzw. Funktionsblöcken. Das Steuersignal wird in einer ersten Teilschaltung, der Ansteuerlogik, aufbereitet und über weitere Komponenten den Treiberschaltungen und schließlich dem Steuereingang des jeweiligen Leistungsschalters zugeführt.

Bei höheren Zwischenkreisspannungen, beispielhaft größer 100V, wird meist die Ansteuerlogik potentialmäßig von den Treiberschaltungen getrennt, da sich die zugehörigen Leistungsschalter auf unterschiedlichem Potential befinden und somit eine spannungsmäßige Isolation unumgänglich ist. Diese Trennung gilt zumindest für den TOP-Schalter, wird aber bei höheren Leistungen auch für den BOT-Schalter auf Grund eines möglichen Verrisses des Massepotentials beim Schalten ausgeführt. Eine derartige Trennung kann zum Beispiel durch Impulsübertrager (galvanische Trennung), durch Optokoppler bzw. Lichtwellenleiter oder mit Hilfe integrierter Schaltungstechnik in einem HVIC (High Voltage Integrated Circuit) realisiert werden. Letztere Variante wird, aufgrund verschiedener Vorteile, wie geringe Abmessungen, niedriger Preis und lange Lebensdauer, mit zunehmender Häufigkeit eingesetzt. Gleichzeitig bieten HVICs die Möglichkeit, ein Hochspannungsbauelement, mit einer Durchbruchspannung größer oder gleich der Zwischenkreisspannung zu integrieren, welche in Schaltkreisen zur Signalpegelumsetzung, in sogenannten Levelshiftern, eingesetzt werden kann. Üblicherweise wird für diese ein lateraler Hochspannungs- MOSFET verwendet.

Der vorgestellte Schaltungsteil ist Teil der Ansteuerschaltung und vorzugsweise ausgeführt als eine integrierte Schaltungsanordnung. Er dient der Übertragung eines Signals von einem Schaltungsteil mit einem niedrigen Bezugspotential (low side) zu einem Schaltungsteil mit einem zeitweise höheren Bezugspotential (high side) oder umgekehrt. Eine solche Anordnung wird zur integrierten und potentialgetrennten Ansteuerung von Leistungshalbleitern benötigt und als Levelshifter bezeichnet.

Es sind zwei grundsätzliche lsolationstechnologien bei HVICs bekannt. Einerseits die SOI-(Silicon on Insulator) Technologien und andererseits pn- isolierte Technologien (Junction Isolation). Die SOI-Technologie bietet eine dielektrische Isolation von Bauelementen und Bauelementgruppen, steht aber derzeit nur bis 800V Spannungsfestigkeit zur Verfügung. Die SOI- Substratwafer sind deutlich teurer als Standardsubstrate, allerdings werden die Kosten durch erhebliche Prozessvereinfachungen kompensiert, die sich aus der dielektrischen Isolation ergeben. Bei pn- isolierten Technologien wird die Sperrspannung durch einen sperrgepolten pn-Übergang aufgenommen. Diese Technik steht derzeit bis 1200V zur Verfügung. Die Herstellung ist allerdings sehr aufwendig und somit kostenintensiv. Weiterhin gibt es technische Probleme, beispielhaft mit Leckströmen und Latch- up Effekten u.a. bei höheren Temperaturen, wie beispielhaft mehr als 125°C Betriebstemperatur, sowie bei Verriss des Massepotentials bei schnellen dynamischen Vorgängen.

Wie in der DE10152930A1 offenbart, lässt sich ein Signal auch schrittweise mittels einer Mehrzahn n gleichartiger kaskadiert, geschalteter bekannter Levelshifter umsetzen, wobei n hier und im Folgenden eine ganze Zahl von zwei oder mehr ist. Die Durchbruchspannung eines einzelnen Hochspannungsbauelements als Teil des Levelshifters muss damit nur den n- ten Teil der Gesamtspannung betragen (Zwischenkreisspannung plus die maximale dynamische Überspannung beim Schalten), vorausgesetzt die gesamte Spannung verteilt sich gleichmäßig auf alle n Levelshifter. Ebenso kann der nutzbare Pegelverschiebungsbereich vergrößert werden, wenn die Anzahl der Stufen erhöht wird. Jedem einzelnen Levelshifter kann eine Signalübertragungsschaltung nachgeschaltet werden. Aus einem resistiv arbeitenden Spannungsteilerschaltkreis, der an das wechselnde Potential am Ausgang der Leistungshalbbrücke gekoppelt ist, werden die Zwischenpotentiale für die negativen Anschlüsse der Versorgungsspannung für den ersten bis (n-1)- ten Signalübertragungsschaltkreis abgeleitet.

Da sich das Potential am Ausgang zyklisch zwischen 0V und einer vorgegebenen Spannung, beispielsweise 600V, ändert, wechselt der Abstand zwischen jeweils zwei Zwischenpotentialen in einem Bereich von beinahe 0V bis 600V/n. Durch diese, an die Schaltphasen der Leistungshalbbrücke gebundene, gleichmäßige Erzeugung von Zwischenpotentialen wird dafür gesorgt, dass die Durchbruchspannung des Hochspannungsbauelements in keinem der n Levelshifter überschritten werden kann.

Die in der DE10152930A1 offenbarte Kaskadierung von n Levelshiftern hat allerdings den Nachteil, dass sich die Anzahl der Querstrompfade, mit einem Querstrompfad pro Levelshifter, um das n- fache, gegenüber einem einzelnen Levelshifter, erhöht. Somit steigt die Stromaufnahme und damit auch die Verlustleistung der Levelshifteranordnung um den Faktor n an. Durch einen Spannungsteilerschaltkreis, der die n-1 Zwischenpotentiale für die Levelshifter erzeugt, fließt zusätzlich ein statischer Querstrom der die Verlustleistung weiter erhöht.

Die Spannungsversorgung für jeden der Signalübertragungsschaltkreise erfolgt über eine Bootstrap- Spannungsversorgung nach dem Stand der Technik, das heißt dass jeweils ein Kondensator an den Betriebsspannungs- und Masseanschluss des Signalübertragungsschaltkreises angeschlossen ist und zyklisch, entsprechend der Schaltphase der Halbbrücke, von einer Gleichstromquelle aufgeladen wird. Da Signalübertragungsschaltkreis separat versorgt wird steigt der Schaltungs- und Platzaufwand für die Versorgung auf den n- fachen Wert an.

Weiterhin sind aus der DE10152930A1 verschiedene Ausführungsformen zur Signalpegelumsetzung in mehreren Stufen bekannt. So kann beispielhaft ein Signal, das aus einem Messkreis zur Erfassung eines Betriebszustandes des TOP-Schalters auf der high side gewonnen wird, über mehrere Levelshifter an eine low side-Signalverarbeitungsschaltung übertragen und einem Mikrocontroller zugeführt werden. Als Hochspannungsbauelement für einen entsprechenden Levelshifter kann ein p-Kanal Hochspannungs- MOSFET genutzt werden. Der Mikrocontroller kann durch dieses Erfassungssignal den Betriebszustand des TOP-Schalters überwachen. Auch für diese Variante gelten die beschriebenen Nachteile in gleicher Weise.

Die Druckschrift von M. VANDER KOOI ET AL "MOS moves into higher- power applications" (ELECTRONICS, Bd. 49, Nr. 13, 24.Juni 1976, Seiten 98 - 103, XP002531713) offenbart ein Power MOSFET integriert in eine Spannungsteilerschaltung, eine Reihenschaltung von Hochspannungstransistoren mit parallel geschalteten Kondensatoren mit einem dazwischen geschalteten Knotenpunkt der mit einem Transistor verbunden ist aufweist und ein Ausgangspannung regelt zwischen den Bezugspotentialen von + 15 V und + 100 V.

Die Druckschrift von B. SERNEELS ET AL: "7.8 - A High Voltage Output Driver in a Standard 2.5 0.25/spl mu/m CMOS Technology" (15. Februar 2004, IEEE INTERNATIONAL SOLID-STATE CIRCUITS CONFERENCE 2004; DIGEST OF TECHNICAL PAPERS. IEEE, PISCATAWAY, NJ, USA, Pages 146 - 155, XP010722195; ISBN: 978-0-7803-8267-1) offenbart ein Hochspannungsausgangstreiber der CMOS Technology, der ebenfalls eine Reihenschaltung von Hochspannungstransistoren mit parallel geschalteter Reihenschaltung von Kondensatoren, die einen Knoten aufweisen die mit dem Steuereingang eines Hochspannungstransistors verbunden ist.

Der Erfindung liegt die Aufgabe zugrunde einen Levelshifter beispielhaft für Ansteuerschaltunhen von Leistungshalbleiterbauelementen vorzugsweise in form mindestens einer integrierten Schaltung derart weiterzubilden, dass der Leistungsverbrauch und der Schaltungsaufwand im Vergleich zum Stand der Technik reduziert sind.

Die Aufgabe wird erfindungsgemäß gelöst durch die Maßnahmen der Merkmale des Anspruchs 1 Bevorzugte Ausführungsformen sind in den Unteransprüchen beschrieben.

Der erfinderische Gedanke geht aus von einer Ansteuerschaltung mit einem Levelshifter zur unidirektionalen Übertragung eines Signals von einem ersten Schaltungsteil mit erstem Potential zu einem zweiten Schaltungsteil mit zweitem Potential. Hierzu weist die Ansteuerschaltung einen Levelshifter, ausgeführt als eine Reihenschaltung einer Mehrzahl von Transistoren auf, wobei der Eingang des Levelshifters mit dem Steuereingang des ersten Transistors der Reihenschaltung verbunden ist. Dieser erste Transistor ist ein Schalttransistor oder ein Hochspannungstransistor während alle weiteren Transistoren Hochspannungstransistoren sind.

Weiterhin weist der Levelshifter einen kapazitiven Spannungsteilerschaltung parallel geschaltet zu den Hochspannungstransistoren auf, wobei dieser kapazitive Spannungsteiler zwischen einem Bezugspotential der low side und einem Bezugspotential der high side geschaltet ist Ebenso weist der Levelshifter Knoten zwischen den einzelnen Kondensatoren auf, die mit den Steueranschlüssen der zugeordneten Hochspannungstransistoren verbunden sind.

Vorteilhaft an der erfindungsgemäßen Topologie ist, dass sich durch die Verwendung von n Hochspannungstransistoren die n- fache Sperrfähigkeit eines einzelnen Hochspannungstransistors erreichen lässt. Gleichzeitig weist die erfindungsgemäße Schaltung, gegenüber der beschriebenen Schaltung nach dem Stand der Technik lediglich einen und nicht n Querstrompfade auf: Weiterhin enthält die erfindungsgemäße Schaltung keine Signatverärbeitungsschaltungen auf Zwischenpotentialen, so dass auch keine aufwendige Stromversorgung dieser Schaltkreise benötigt wird.

Somit kann zum einen der Leistungsverbrauch und zum anderen der Schaltungsaufwand gegenüber dem Stand der Technik verringert werden. Dies hat einen geringeren Platz-und somit auch einen geringeren Kostenbedarf zur Folge.

Besonders bevorzugte Ausbildungen des Levelshifters sind in der jeweiligen Beschreibung der Ausführungsbeispiele genannt. Die erfinderische Lösung wird zudem an Hand dieser Ausführungsbeispiele der Fig. 1 bis 6 weiter erläutert.

Fig. 1 zeigt einen ersten erfindungsgemäßen Levelshifter in zwei Ausführungsformen.

Fig. 2 zeigt Simulationenergebnisse eines Levelshifters gemäß Fig. 1 a.

Fig. 3 zeigt eine zweite Ausgestaltung eines erfindungsgemäßen Levelshifters.

Fig. 4 zeigt vergleichende Simulationen der Levelshifter gemäß Fig. 1a und Fig. 3.

Fig. 5 zeigt eine dritte erfindungsgemäße Ausbildung eines Levelshifters.

Fig. 6 zeigt eine vierte erfindungsgemäße Ausbildung eines Levelshifters.

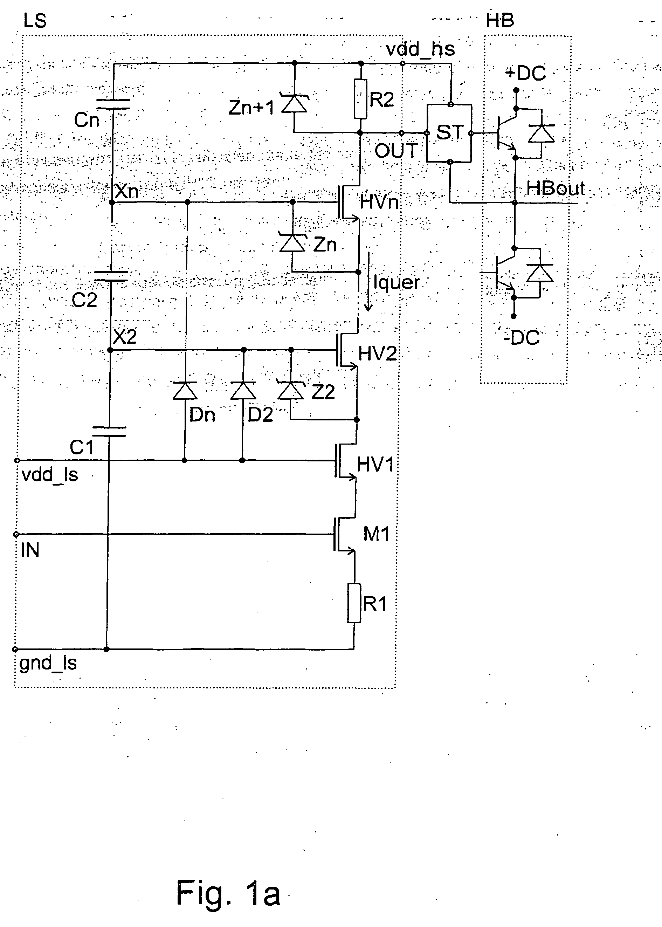

Fig. 1a zeigt eine Anordnung mit einem erfindungsgemäßen Levelshifters (LS), wobei ein Schalttransistor (M1) und eine Anzahl n Hochspannungstransistoren (HV1 bis HVn) in Reihe geschaltet werden. Alle Transistoren sind bei einer Signalübertragung von der low side zur high side vom n-Kanal Typ. Ein erster Widerstand (R1) wird an Source des Schalttransistors (M1), und an die Masseleitung (gnd_Is) der low side angeschlossen. Ein zweiter Widerstand (R2) wird an Drain des letzten Hochspannungstransistors (HVn) und an den Betriebsspannungsanschluss der high side (vdd_hs) angeschlossen. Der Eingang des Levelshifters, an den das zu übertragende Signal übergeben wird, ist direkt mit dem Gate des Schalttransistors (M1) verbunden. Der Drain- Anschluss des letzten Hochspannungstransistors (HVn) ist der Ausgang (OUT) des Levelshifters (LS). An diesen wird eine Signalauswerteschaltung (ST), beispielhaft ein Schmitt- Trigger angeschlossen. Die Masseleitung der Signalauswerteschaltung (ST) ist an den Mittelknoten (HBout) einer Leistungshalbbrücke (HB) angeschlossen. Der Mittelknoten (HBout) der Halbbrücke (HB) bildet das Bezugspotential (gnd_hs) der high side und befindet sich je nach Schaltzustand der Leistungshalbleiter (TOP, BQT) entweder nahe der Zwischenkreisspannung (UZ) an der positiven Elektrode (+DC) des Zwischenkreises oder nahe dem Potential an der negativen Elektrode (-DC) des Zwischenkreises, die üblicherweise mit der Masseleitung (gnd_ls) verbunden ist.

Die Betriebsspannungsversorgung für die Schaltkreise auf der high side kann mit bekannten Techniken realisiert werden. Dazu gehören unter anderem die Bootstrap-Spannungsversorgung oder DC/DC-Wandler.

Das Gate des ersten Hochspannungstransistors (HV1) wird direkt an die Betriebsspannungsleitung (vdd_Is) der low side angeschlossen und erhält somit immer ein gleich bleibendes Potential, beispielhaft 15V, das von einer Gleichspannungsquelle erzeugt wird. An die Gate- Anschlüsse der weiteren Hochspannungstransistoren (HV2 bis HVn) ist jeweils die Kathode einer zugeordneten ersten Diode (D2 bis Dn), wobei diese Dioden auch als Reihenschaltung einer Mehrzahl von Dioden ausgestaltet sein können, angeschlossen. Die Anoden der ersten Dioden (D2 bis Dn) sind an das Potential (vdd_ls) angeschlossen. Bei einem Schaltzustand bei dem das Bezugspotential von high side und low side gleich ist, das heißt der Wert von (gnd_hs) ist gleich dem Wert von (gnd_Is), sind die ersten Dioden (D2 bis Dn) in Durchlassrichtung gepolt und an den Gate- Anschlüssen der zugeordneten Hochspannungstransistoren (HV2 bis HVn) liegt ein definiertes Potential an, welches nahezu der Spannung entspricht, die von der Gleichspannungsquelle erzeugt wird, abzüglich der Dioden- Flussspannungen.

Auf das Gate am Steuereingang (IN) des Schalttransistors (M1) wird ein von der Ansteuerlogik des Gatetreibers aufbereitetes periodisch auftretendes Steuersignal, beispielhaft ein rechteckförmiger Impuls, gegeben. Das Steuersignal bewirkt ein Schalten des Schalttransistors (M1). Dadurch werden die Hochspannungstransistoren (HV1 bis HVn) ein- und ausgeschaltet. Beim Einschalten fließt ein Querstrom (lquer) durch den Levelshifter (LS). Das digitale Eingangssignal wird somit in ein Stromsignal gewandelt und so über den Levelshifter (LS) übertragen. Der.Spannungsabfall über dem zweiten Widerstand (R2) ist proportional zum Querstrom (Iquer).

Die an den Ausgang (OUT) des Levelshifters (LS) angeschlossene Signalauswerteschaltung (ST) wandelt das übertragene Signal in ein digitales Signal zurück. Der erfindungsgemäße Levelshifter benötigt im Gegensatz zur Ausbildung nach dem Stand der Technik keine weiteren Signalübertragungsschaltungen auf n-1 Zwischenpotentialen.

Anschließend wird das Signal einer weiteren logischen Signalverarbeitung unterzogen oder direkt an den Treiber für den TOP-Schalter übergeben. Ein auf die high side übertragenes Signal führt zu einem Schaltvorgang des TOP-Schalters der Leistungshalbbrücke (HB). Bei einem Schaltvorgang der Leistungshalbbrücke (HB), bei der gleichzeitig oder kurz nacheinander der BOT-Schalter aus und der TOP-Schalter eingeschaltet werden, steigt die Spannung am Ausgang der Halbbrücke (HBout) mit einer schnellen Änderung pro Zeiteinheit (du/dt), beispielhaft 10kV/µs an. In gleichem Maße steigt gleichzeitig das Bezugspotential der high side an. Nach dem Schaltvorgang liegt zwischen den Potentialen (vdd_hs und vdd_ls bzw. zwischen gnd_hs und gnd_ls) etwa die Zwischenkreisspannung (UZ) an. Der größte Teil der Spannung fällt über den Hochspanhungstransistoren (HV1 bis HVn) ab.

Ein kapazitiver Spannungsteiler zwischen (vdd_hs) und (gnd_Is), bestehend aus Kondensatoren (C1 bis Cn), die untereinander in Reihe geschaltet sind, erzeugt bei einer zeitlichen Änderung der Ausgangsspannung der Halbbrücke (HB) n-1 Zwischenpotentiale an den Knoten (X2 bis Xn), die jeweils an die Gates der Hochspannungstransistoren (HV2 bis HVn) angeschlossen sind. Bei geeigneter Dimensionierung der Kondensatoren (C2 bis Cn) teilt sich die ändernde Spannung gleichmäßig über den Knoten (X2 bis Xn) auf, so dass über jedem Kondensator eine Spannung abfällt, die dem n-ten Teil der gerade anliegenden Spannung zwischen (vdd_hs) und (gnd_Is) entspricht.

Die maximale Spannung die über einem Kondensator (C1 bis Cn) abfallen kann entspricht etwa dem n- ten Teil der Zwischenkreisspannung (UZ). Die durch die Kondensatoren erzeugte Teilung der Spannung bleibt auch nach dem Abklingen der zeitlichen Spannungsänderung erhalten, da die Kondensatoren (C1 bis Cn) die gespeicherte Ladung halten. Wenn das Bezugspotential der high side höher ist als das Bezugspotential der low side dann sind die ersten Dioden (D2 bis Dn) in Sperrrichtung gepolt. Diese Dioden (D2 bis Dn) benötigen eine Durchbruchspannung die mindestens so groß ist wie die maximal auftretende Spannung zwischen den Knoten (X2 bis Xn) und (vdd_Is).

An jedem Hochspannungstransistor (HV2 bis HVn) ist weiterhin jeweils eine Zener-Diode (Z2 bis Zn) angeschlossen, wobei die Kathode am Gate und die Anode am Source des zugeordneten Hochspannungstransistors angeschlossen ist. Die Gate-Source-Spannung jedes Hochspannungstransistors (HV2 bis HVn) wird dadurch nach oben auf einen Wert begrenzt der unterhalb der Durchbruchspannung der Gate-Source-Strecke eines Hochspannungstransistors liegt und verhindert somit einen Durchbruch des Bauelements. Die Zener-Spannung der Zener-Diode, typischerweise nur einige Volt, kann für die Betrachtung der Zwischenpotentialeinstellung gegenüber der Zwischehkreisspannung vernachlässigt werden.

Somit ist das Potential am Gate eines Hochspannungstransistors auf Source des gleichen Transistors bzw. auf Drain des darunter liegender Transistors bezogen. Über der Drain-Source-Strecke eines jeden Hochspannungstransistors (HV1 bis HVn) kann somit etwa nur maximal der n- te Teil der Zwischenkreisspannung (UZ) abfallen. Somit lässt sich eine Spannungsfestigkeit des gesamten Levelshifters (LS) erreichen, die etwa dem n- fachen der Durchbruchspannung der Drain-Source-Strecke eines Hochspannungstransistors entspricht.

Eine weitere Zener-Diode (Zn+1) ist parallel zum zweiten Widerstand (R2) geschaltet. Die Kathode von (Zn+1) ist an (vdd_hs) die Anode an den Ausgang des Levelshifters (LS) angeschlossen. Dadurch wird der Spannungsabfall über (R2), der bei einem Querstrom durch den Levelshifter auftritt, derart begrenzt, dass das Potential am Ausgang (OUT) des Levelshifters das Massepotential (gnd_hs) des nach geschalteten Schmitt- Triggers (ST) nicht unterschreitet und gleichzeitig einen Spannungshub am Ausgang garantiert, der eine Unterscheidung zwischen übertragenem high- und low-Pegel ermöglicht. Ein bevorzugter Wert ist die Höhe der Betriebsspannung der high side, z.B. 15V. Durch die Einstellung der Zwischenpotentiale an den Gates der Hochspannungstransistoren (HV2 bis HVn) mittels des kapazitiven Spannungsteilers ist eine Signalübertragung über den Levelshifter (LS), während aller Betriebszustände der Halbbrücke (HB), möglich.

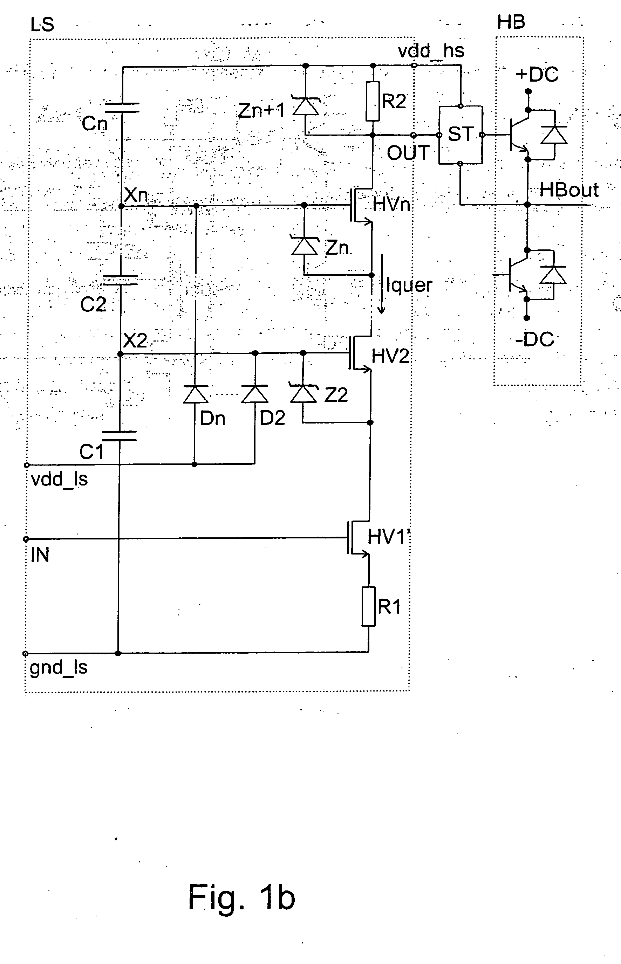

Eine weitere vereinfacht Ausgestaltung gemäß Fig. 1 b des Levelshifters verzichtet auf den Schalttransistor (M1) und verbindet den Eingang (IN) direkt mit dem Gate des ersten Hochspannungstransistors (HV1'). Im Gegensatz zu Ausgestaltung nach Fig. 1a sind die ersten Dioden (D2 bis Dh) nicht mit dem Gate des ersten Hochspannungstransistors (HV1') verbunden. Die weitere Ausgestaltung ist identisch derjenigen gemäß Fig. 1 a. Der Verzicht auf den Schalttransistor (M1, gemäß Fig. 1 a) hat allerdings zur Folge, dass bei gleicher Schaltleistung die Übertragungsgeschwindigkeit geringer ist.

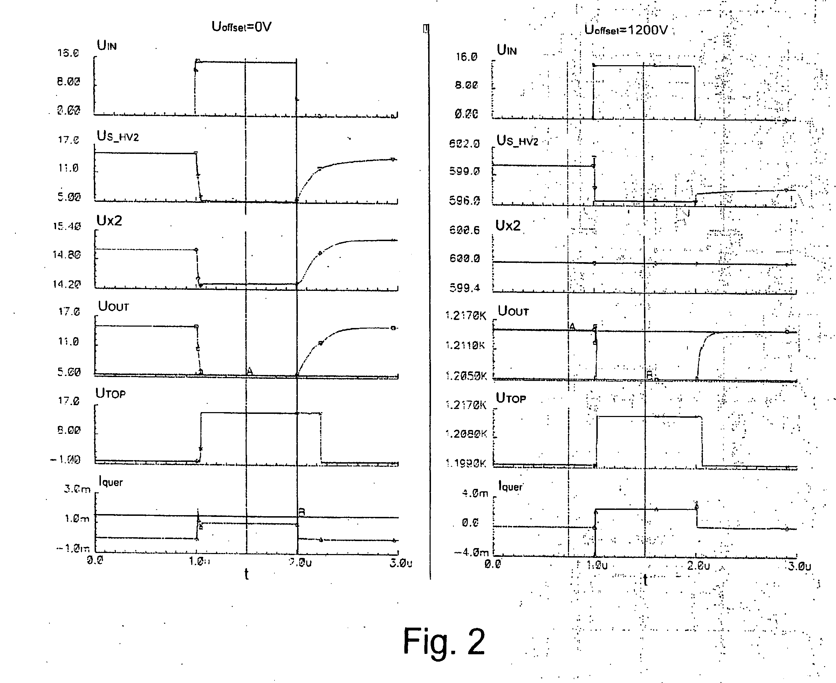

In Fig. 2 ist das transiente Übertragungsverhalten des Levelshifters gemäß Fig. 1 a im Rahmen einer Simulation dargestellt. Hierbei ist eine Ausführungsform mit zwei Hochspannungstransistoren für die Simulation gewählt worden. Aus den Abbildungen ist ersichtlich, dass ein Ansteuersignal (IN) sowohl bei gleichem Bezugspotential von high side und low side (Uoffset=0V) als auch bei einem high side Bezugspotential in der Nähe der Zwischenkreisspannung (Uoffset=600V/1200V) von low side nach high side übertragen wird (OUT). Der Schmitt-Trigger erkennt das übertragene Signal korrekt. Das Potential am Knoten X1 stellt sich bei C1=C2 wie gewünscht auf etwa auf die Hälfte der Zwischenkreisspannung von 600V ein.

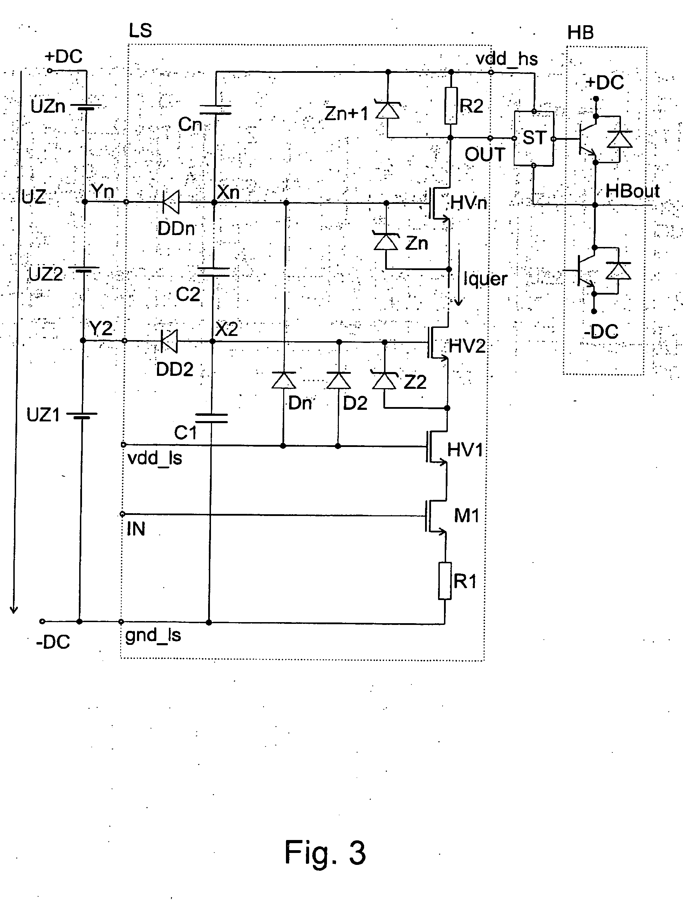

Fig. 3 zeigt eine zweite gegenüber Fig. 1a erweiterte, Ausführungsform des erfindungsgemäßen Levelshifiters (LS). Eine Zwischenkreisspannung (UZ) wird aus n gleichartigen Spannungsquellen (UZ1 bis UZn) erzeugt die untereinander in Reihe geschaltet sind, wobei jede Spannungsquelle die gleiche Teilspannung UZ/n erzeugen kann. Das Potential am weiteren Knoten (Y2) entspricht somit dem Potential das maximal am Knoten (X2) auftreten soll. Analog gilt die Aussage für die Knoten (Y3 und X3 bis Yn und Xn). Dies soll an einem einfachen Beispiel weiter erläutert werden. Die Zwischenkreisspannung des Systems beträgt beispielhaft 600V. Die Durchbruchspannung der verfügbaren Hochspannungstransistoren beträgt mindestens 300V ist aber kleiner als 600V. Um die erforderliche Spannungsfestigkeit des Levelshifters zu garantieren müssen also zwei Hochspannungstransistoren in Reihe geschaltet werden, d.h. n=2. Das Potential am Gate von (HV2) wird durch den kapazitiven Spannungsteiler (C1, C2) eingestellt. Wird der Zwischenkreis nun aus zwei Spannungsquellen (UZ1=UZ2) mit jeweils 300V zusammengesetzt, dann entspricht das Potential am Mittelknoten (Y2) des Zwischenkreises genau dem Potential (300V), das am Knoten (X2) (Gate von HV2) anliegen muss um eine annähernd gleichmäßige Spannungsverteilung über den Hochspannungstransistoren (jeweils 300V) zu garantieren.

Zusätzlich zur Anordnung gemäß Fig.1 wird die Ausführungsform nach Fig. 3 um die weitern Dioden (DD2 bis DDn) ergänzt. Die Anoden dieser Dioden werden jeweils an die Knoten (X2 bis Xn), die entsprechenden Kathoden an die weiteren Knoten (Y2 bis Yn) angeschlossen. Die Signalübertragung über den Levelshifter (LS) erfolgt analog zur ersten Ausführungsform. Die Einstellung der Potentiale an den Knoten (X2 bis Xn) bei einem Schaltvorgang bei dem der BOT-Schalter ein- und der TOP-Schalter ausgeschaltet wird, wird weiterhin durch die Kondensatoren (C1 bis Cn) erreicht. Das maximale Potential an den Knoten (X2 bis Xn) wird dabei auf das konstante Potential an den entsprechenden weiteren Knoten (Y2 bis Yn) nach oben begrenzt. Wenn das Potential an einem Knoten (Xk) größer wird als das Potential an einem weiteren Knoten (Yk) zuzüglich der Flussspannung der weiteren Diode (DDk) (2 ≤ k ≤ n) dann öffnet sich die weitere Diode (DDk) und das Potential am Knoten (Xk) kann nicht weiter ansteigen. Zum Einsetzen der Begrenzung kommt es nur, wenn die Kapazität einer oder mehrerer der Kondensatoren (C1 bis Cn) vom gewünschten Wert abweicht bzw. parasitäre Kapazitäten parallel zu einem oder mehreren der Kondensatoren (C1 bis Cn) wirken. Zu einer Abweichung der Kapazität eines Kondensators vom gewünschten Wert kann es beispielsweise durch Parameterstreuung bei der Herstellung kommen. Die Kapazitätsabweichung führt in Folge zu einer unsymmetrischen Spannungsaufteilung.

Durch die Begrenzung der Potentiale an den Knoten (X2 bis Xn) auf einen oberen Wert wird jedoch nicht umfassend sichergestellt, dass die Durchbruchspannung eines Hochspannungstransistors (HV1 bis HVn) nicht überschritten werden kann. Die soll wieder am Beispiel n=2 erläutert werden. Sind C1 und C2 gleich groß, dann stellt sich das Potential am Gate von (HV2) durch den Spannungsteiler etwa auf UZ/2=300V ein und die Begrenzung setzt nicht ein. Ist die Kapazität von (C2) größer als von (C1), dann begrenzt die weitere Diode (DD2) das Potential am Gate von (HV2) (Knoten X2) auf 300V. In beiden Fällen ist auch die Drain-Source-Spannung von (HV1 und HV2) nicht größer als maximal 300V, so dass die Durchbruchspannung der Transistoren nicht überschritten wird. Ist die Kapazität von (C1) größer als von (C2), dann fällt über (C2) der größte Teil der gerade anliegenden Spannung zwischen (vdd_hs und gnd_Is) ab. Somit kann die Drain-Source-Spannung von (HV2) die Durchbruchspannung überschreiten, das heißt die gewünschte Spannungsfestigkeit des Levelshifters (LS) ist gegebenenfalls nicht mehr sichergestellt. Somit stellt der Fall bei dem die Kapazität von (C2) größer ist als von (C1) die bevorzugte Variante dar, da die Spannungsbegrenzung am Gate von (HV2) immer wirksam wird und die Durchbruchspannung von (HV2) nicht überschritten werden kann. Um für die Ausführungsform mit n in Reihe geschalteten Hochspannungstransistoren ein analoges Schaltungsverhalten zu erreichen, werden die Kapazitäten von (C1 bis Cn) so dimensioniert, dass die Kapazitäten der jeweiligen Kondensatoren (C1 bis Cn) mit ihrer Ordnungszahl (1 bis n) steigen. Diese vorteilhafte Ausführungsform des Levelshifters (LS) eignet sich somit für Anwendungen bei denen die Werte der Kondensatoren (C1 bis Cn) stark streuen bzw. bestimmte parasitäre Kapazitäten der Anordnung nicht genau berechenbar sind bzw. durch die Applikation Veränderungen unterliegen.

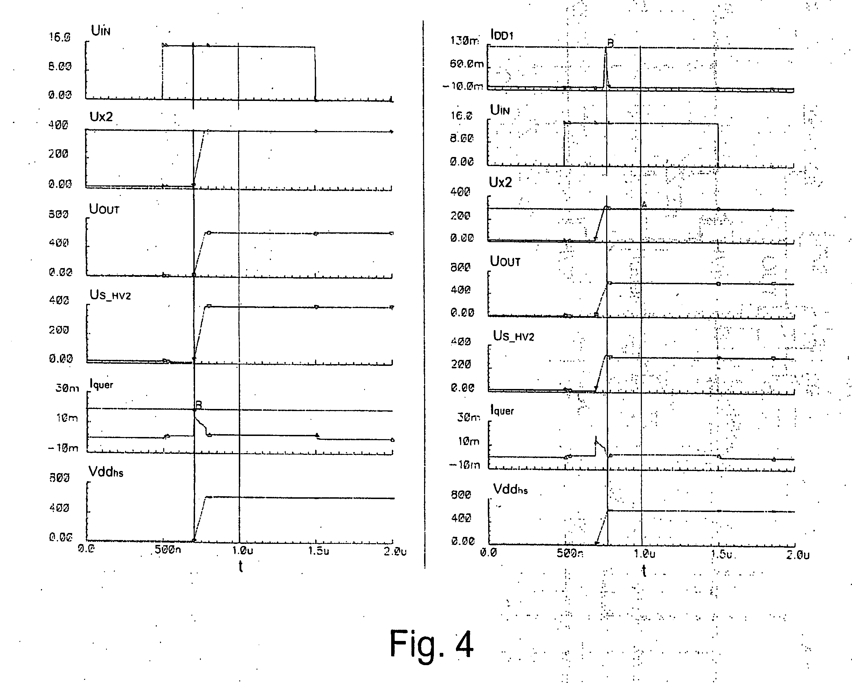

Fig. 4 zeigt das simulierte Verhalten eines Levelshifters für n=2 gemäß Fig.1a (linker Teil der Darstellung) und gemäß Fig.3 (rechter Teil der Darstellung) während des Einschaltvorganges dar, wobei die Kapazität von (C1) jeweils deutlich kleiner als von (C2) ist. Durch die ungleichmäßige kapazitive Belastung steigt das Zwischenpotential am Knoten (X2) beim Levelshifter nach Fig.1a beim schnellen du/dt des high side Bezugspotentials (Vdd_hs) auf einen Wert größer als UZ/2=300V an (ca. 395V). Beim Levelshifter nach Fig. 3 steigt das Zwischenpotential am Knoten (X2) nicht über UZ/2, da die beschriebehe Begrenzung durch die weitere Diode (DD2) wirksam wird.

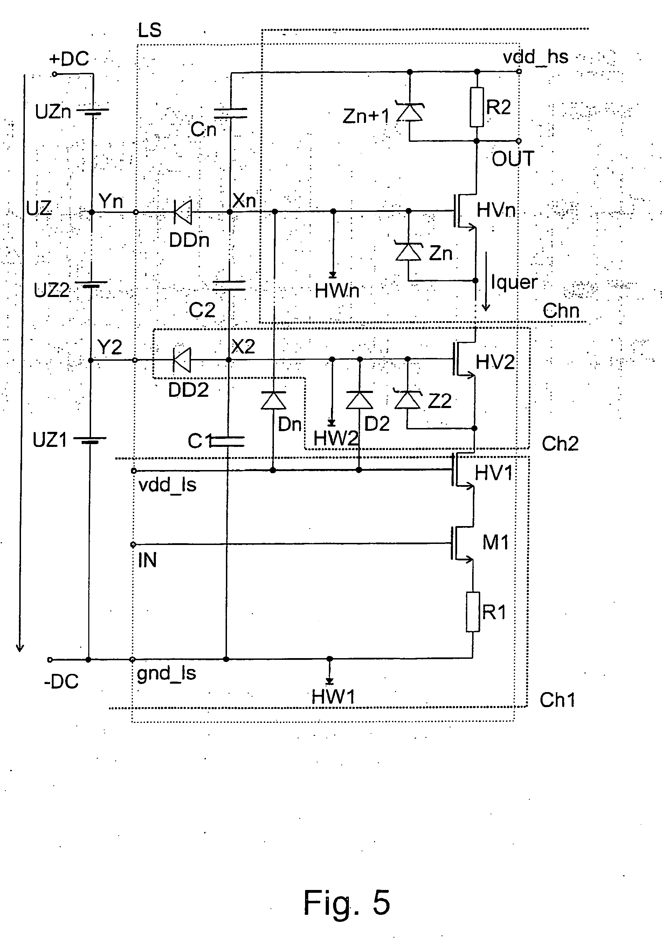

Fig. 5 stellt eine weitere Ausführungsform des erfindungsgemäßen Levelshifters (LS) dar, mit der es möglich ist Signale über eine Potentialbarriere zu übertragen, die größer ist als die Spannungsfestigkeit zwischen high side und low side in einer integrierten Schaltung. Diese Spannungsfestigkeit wird zum einen bestimmt durch die Durchbruchspannung des integrierten Levelshifters, die bei herkömmlichen Topologien von der Durchbruchspannung des integrierten Hochspannungstransistors bestimmt wird, und zum anderen durch die Spannungsfestigkeit der lsolation zwischen high side und low side. Die Spannungsfestigkeit der lsolation wird von der Halbleitertechnologie bestimmt und kann mit schaltungstechhischen Maßnahmen nicht erhöht werden. Solange die Durchbruchspannung des integrierbaren Hochspannungstransistors mindestens n- mal kleiner ist als die Spannungsfestigkeit der Isolation, kann die Spannungsfestigkeit des Levelshifters, wie oben beschrieben, durch die Verwendung von n Hochspannungstransistoren in einem HVIC auf den n- fachen Wert, also maximal auf die Spannungsfestigkeit der Isolation erhöht werden.

Da in den meisten Fällen die Durchbruchspannung der Isolation und des Hochspannungstransistors annähernd gleich groß sind, kann die Spannungsfestigkeit des gesamten Levelshifters nur auf den n- fachen Wert erhöht werden, wenn jeder der n Hochspannungstransistoren auf einem separaten Substrat integriert wird. Somit können mit 600V-lsolationsverfahren nach dem Stand der Technik höhere Potentialdifferenzen überwunden werden. Werden beispielsweise zwei Chips eingesetzt kann eine integrierte Schaltungsanordnung auch für die Spannungsklasse von 1200V realisiert werden.

Die Ausführungsform in Fig. 5 unterscheidet sich von derjenigen gemäß Fig. 3, dadurch dass der Levelshiffer auf n separate Chips (Ch1 is Chn) aufgeteilt ist, wobei auf jedem Chip einer der n Hochspannungstransistoren (HV1 bis HVn) integriert wurde. Beispielhaft wird angenommen, dass für die Herstellung der Chips eine SOI-Technologie verwendet wurde. Auf Chip (Ch1) sind der Hochspannungstransistor (HV1), der Schalttransistor (M1) und der erste Widerstand (R1) integriert. Gegebenenfalls können auf Chip (Ch1) weitere Schaltungen wie z.B. eine Logikbaugruppe sowie ein Treiber für einen BOT-Schalter integriert werden.

[44] Die Chips (Ch2 bis Chn-1) enthalten jeweils einen Hochspannungstransistor (HV2 bis HVn-1) sowie die zugeordneten Zener- Dioden (Z2 bis Zn-1), die wie bei den vorgenannten Ausführungsformen an die Hochspannungstransistoren (HV2 bis HVn-1) angeschlossen sind. Die ersten und zweiten Dioden (D2 bis Dn und DD2 bis DDn) können auf dem jeweiligen Chip (Ch2 bis Chn) integriert werden, wenn die maximal auftretende Sperrspannung an der Diode kleiner als die Spannungsfestigkeit der Isolation des Chips ist. Wenn die maximal auftretende Sperrspannung an den Dioden (D2 bis Dn und DD2 bis DDn) größer als die Spannungsfestigkeit der lsolation des Chips ist, dann müssen die entsprechenden Dioden als externe Bauelemente ausgeführt werden.

Der Chip (Chn) enthält den Hochspannungstransistor (HVn), die Zener- Dioden (Zn, Zn+1) und den Widerstand (R2). Gegebenenfalls konnen auf dem Chip (Chn) alle weiteren Schaltungsteile der high side, z.B. die Signalauswerteschaltung und der Treiber für den TOP-Schalter integriert werden. Die Kondensatoren (C1 bis Cn) können in den zugeordneten Chips (Ch1 bis Chn) integriert werden. Aufgrund der hohen benötigten Chipfläche für die Kondensatoren ist die Umsetzung mit externen diskreten Bauelementen eine bevorzugte Ausführungsform.

Selbstverständlich ist eine Ausführung dieses Levelshifters ohne die spannungsbegrenzenden Dioden (DD2 bis DDn) analog zu den ersten Ausführungsformen nach Fig. 1a und b möglich.

Die rückseitige Elektrode jedes Chips (Ch1 bis Chn) muss, um eine korrekten Funktion der Schaltung gewährleisten zu können, ein Potential tragen, das nah am niedrigsten Potential des jeweiligen Chips liegt. Eine Änderung des Potentials am Rückseitenkontakt eines Chips verändert das elektrische Verhalten der Bauelemente an der Oberseite. Dieser Effekt ist als Rückseitenkanaleffekt (backgate effect) bekannt. Bei pn isolierten Technologien nach dem Stand der Technik muss der Rückseitenkontakt immer das niedrigste im Chip auftretende Potential tragen, da andernfalls der rückseitige pn-Übergang, der die Spannung zwischen high side und low side aufnehmen soll in Durchlassrichtung gepolt ist und so die Funktion nicht erfüllen kann.

Im Gegensatz dazu ist bei einer SOI-Technologie der Rückseitenkontakt (HW) dielektrisch von den Bauelementen auf der Oberseite des Wafers isoliert, so dass auch bei einem höheren Potential am Rückseitenkontakt die Isolation nicht beeinträchtigt wird. Ein merklicher Einfluss des erhöhten Rückseitenpotentiales auf das elektrische Verhalten der Bauelemente tritt typischerweise erst ab einigen 10V auf. Dieser Vorteil der SOI-Technologie wird bei der erfindungsgemäßen Schaltung in dieser genutzt. Der Rückseitenkontakt von-Chip 1 (HW1) ist mit der Masseleitung des Chips (gnd_ls) verbunden. Die Rückseitenkontakte (HW2 bis HWn) der Chips (Ch2 bis Chn) sind jeweils an die Gate- Anschlüsse der entsprechenden Hochspannungstransistoren (HV2 bis HVn) bzw. an die entsprechenden Knoten (X2 bis Xn) angeschlossen. Das Potential am Source- Anschluss eines Hochspannungstransistors ist immer das niedrigste Potential das in dem Chip auftritt in den der Hochspannungstransistor integriert wurde. Die Zener-Dioden (Z2 bis Zn) begrenzen die Gate- Source- Spannung der Transistoren (HV2 bis HVn) auf einige Volt, beispielhaft 15V, und halten so das Potential am Source des integrierten Hochspannungstransistors nah am Potential des Rückseitenkontaktes des jeweiligen Chips. Die Chips (Ch1 bis Chn) sind untereinander isoliert, vorteilhafterweise aber in einem gemeinsamen Package, angeordnet. Die elektrische Verbindung zwischen den Chips kann mit bekannten Verfahren, zum Beispiel einem Bond-Verfahren erreicht werden.

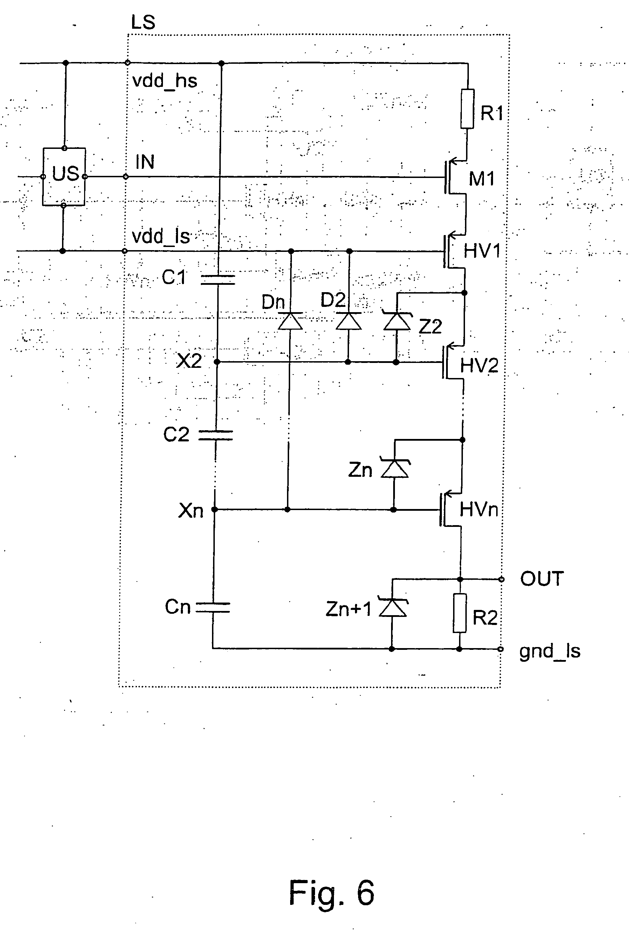

Fig.6 zeigt einen Levelshifter in einer vierten Ausführungsform. Bei der hier vorgestellten Variante handelt es sich um einen Levelshifter, der ein Spannungssignal, das auf der high side erzeugt wurde auf die low side überträgt um dort von einer Logikschaltung ausgewertet zu werden. Ebenso kann das Signal von der low side an einen Mikrocontroller übergeben werden. Das Spannungssignal kann beispielsweise ein Statussignal einer Überwachungsschaltung (US) sein, die den Betriebszustand von bestimmten Teilschaltungen der high side erfasst, z.B. eine Überwachung der Betriebsspannung oder der Temperatur einer Teilschaltung. Der Mikrocontroller kann somit das Statussignal einen Betriebszustand auf der high side überwachen.

Der Levelshifter (LS) ist komplementär zur Ausführungsform gemäß Fig.1a aufgebaut. Das heißt, es wird dieselbe Topologie verwendet, mit dem Unterschied, dass sowohl die n Hochspannungstransistoren (HV1 bis HVn) als auch der Schalttransistor (M1) vom p-Kanal Typ sind. Der erste Widerstand (R1), die Transistoren (M1, HV1 bis HVn) und der zweite Widerstand (R2) sind wiederum in Reihe geschaltet. Ein Anschluss des ersten Widerstands (R1) wird an Source des Schalttransistors (M1), der andere Anschluss an die Betriebsspannungsleitung (vdd_hs) der high side angeschlossen.

Der zweite Widerstand (R2) wird an Drain des Transistor (HVn) und an die Masseleitung (gnd_ls) der low side angeschlossen. Der Gate- Anschluss des Schalttransistors (M1) ist der Eingang (IN) des Levelshifters (LS), an den das zu übertragende Signal übergeben wird. Der Drain- Anschluss des Hochspannungstransistors (HVn) ist der Ausgang (OUT) des Levelshifters. An diesen wird eine Signalauswerteschaltung, z.B. ein Schmitt-Trigger angeschlossen. Die Masse der Signalauswerteschaltung ist an die Masseleitung (gnd_ls) der low side angeschlossen.

An die Gate- Anschlüsse der Hocbspanpungstransistoren (HV2 bis HVn) ist jeweils die Anode einer der ersten Dioden (D2 bis Dn) angeschlossen. Die Kathoden der Dioden sind an das Potential (gnd_hs) angeschlossen. Bei einem Schaltzustand, bei dem Bezugspotential von high side und low side gleich sind, dass heißt (vdd_hs = vdd_ls bzw. gnd_hs = gnd_ls), sind die Dioden (D2 bis Dn) in Durchlassrichtung gepolt und an den Gate- Anschlüssen der Hochspannungstransistoren (HV2 bis HVn) liegt ein definiertes Potential an, welches nahezu dem Potential an (gnd_hs) entspricht. Eine Zener- Diode (Zn+1) ist parallel zum zweiten Widerstand (R2) geschaltet. Die Anode von (Zn+1) ist an (gnd_Is), die Kathode an den Ausgang (OUT) des Levelshifters (LS) angeschlossen. (Zn+1) begrenzt den Spannungsabfall über (R2) wie bei der ersten Ausführungsform in Fig. 1 beschrieben.

Der kapazitive Spannungsteiler zwischen (vdd_hs) und (gnd_ls), bestehend aus den Kondensatoren (C1 bis Cn), die untereinander in Reihe geschaltet sind, ist wie bei der ersten Ausführungsform angeschlossen und übernimmt die Einstellung des Potentials an den Gate- Elektroden der Hochspannungstransistoren (HV2 bis HVn) bei einer zeitlichen Änderung des Bezugspotentials der high side in der beschriebenen Weise. Analog zur ersten Ausführungsform gemäß Fig.1a ist an jeden Hochspannungstransistor (HV2 bis HVn) jeweils eine Zener-Diode (Z2 bis Zn) angeschlossen, wobei die Kathode am Source und die Anode am Gate des Hochspannungstransistors angeschlossen ist. Die Gate-Source-Spannung jedes Hochspannungstransistors (HV2 bis HVn) wird dadurch begrenzt und somit der Durchbruch des. Bauelements verhindert. Die Signalübertragung eines Spannungssignals von der high side auf die low side erfolgt analog zur Signalübertragung von der low side auf die high side bei der ersten Ausführungsform. Das Steuersignal wird auf das Gate des Schalttransistors (M1) gegeben und bewirkt ein Schalten des Schalttransistors (M1). Dadurch werden die Hochspannungstransistoren (HV1 bis HVn) ein- und ausgeschaltet. Beim Einschalten fließt ein Querstrom (Iquer) durch den Levelshifter (LS). Das digitale Eingangssignal wird in ein Stromsignal gewandelt und so über den Levelshifter übertragen. Der Spannungsabfall über den zweiten Widerstand (R2) ist proportional zum Querstrom. Die an den Ausgang (OUT) des Levelshifters (LS) angeschlossene Signalauswerteschaltung (ST) wandelt das übertragene Signal in ein digitales Signal um.

## Patentansprüche

1. Levelshifter (LS), zur unidirektionalen Übertragung eines Signals von einem ersten Schaltungsteil mit erstem Potential zu einem zweiten Schaltungsteil mit zweitem Potential,
mit einer Reihenschaltung einer Mehrzahl von Transistoren, wobei der Eingang (IN) des Levelshifters (LS) mit dem Steuereingang des ersten Transistors der Reihenschaltung verbunden, dieser erste Transistor ein Schalttransistor (M1) oder ein Hochspannungstransistor (HV1') ist und alle weiteren Transistoren Hochspannungstransistoren sind,
und mit einer kapazitiven Spannungsteilerschaltung parallel geschaltet zu den Hochspannungstransistoren (HV1 bis HVn),
wobei diese kapazitive Spannungsteilerschaltung zwischen einem Bezugspotential (gnd_ls) der low side und einem Bezugspotential (vdd_hs) der high side geschaltet ist und Knoten (X2 bis Xn) zwischen den einzelnen Kondensatoren (C1 bis Cn) angeordnet sind, die mit den Steueranschlüssen der zugeordneten Hochspannungstransistoren (HV2 bis HVn) verbunden sind und wobei zwischen einer eingangsseitigen Spannungsversorgung (vdd_ls) des Levelshifters (LS) und den Steuereingängen der Hochspannungstransistoren (HV2 bis HVn) jeweils erste Dioden (D2 bis Dn) geschaltet sind..

2. Levelshifter nach Anspruch 1,
wobei alle Kondensatoren (C1 bis Cn) die gleiche Kapazität aufweisen.

3. Levelshifter nach Anspruch 1,
wobei die Kapazitäten der jeweiligen Kondensatoren (C1 bis Cn) mit ihrer Ordnungszahl (1 bis n) steigen.

4. Levelshifter nach Anspruch 1,
wobei der Schalttransistor (M1) wie auch die Hochspannungstransistoren (HV1 bis HVn) bei einer Signalübertragung von der low side zur high side vom n-Kanal Typ sind, ein erster Widerstand (R1) in Reihe vor den ersten Transistors (M1 oder HV1') und ein zweiter Widerstand (R2) in Reihe nach dem letzten Hochspannungstransistors (HVn) geschaltet ist.

5. Levelshifter nach Anspruch 1,
wobei der Schalttransistor (M1) wie auch die Hochspannungstransistoren (HV1 bis HVn) bei einer Signalübertragung von der high side zur low side vom p-Kanal Typ sind, ein erster Widerstand (R1) in Reihe vor den ersten Transistors (M1 oder HV1') und ein zweiter Widerstand (R2) in Reihe nach dem letzten Hochspannungstransistors (HVn) geschaltet ist.

6. Levelshifter nach Anspruch 1,
wobei Zener-Dioden (Z2 bis Zn) zur Spannungsbegrenzung zwischen Steuereingang und Source der zugeordneten Hochspannungstransistoren (HV2 bis HVn) angeschlossen sind.

7. Levelshifter nach Anspruch 7,
wobei eine weitere Zener- Diode (Zn+1) zur Spannungsbegrenzung parallel zum Widerstand (R2) geschaltet ist.

8. Levelshifter nach Anspruch 1,
wobei die Knoten (X2 bis Xn) jeweils mittels zweiter Dioden (DD2 bis DDn) mit zugeordneten externen Anschlüssen des Levelshifters (LS) verbunden sind.

9. Levelshifter nach Anspruch 1,
wobei der Levelshifter (LS) monolithisch integriert auf einem oder geeignet verteilt auf einer Mehrzahl von Substraten (S1 bis Sn) ausgebildet ist.

## Claims

1. Level shifter for the unidirectional transmission of a signal from a first circuit section at a first potential to a second circuit section at a second potential,
having a series circuit of a plurality of transistors, wherein the input (IN) of the level shifter (LS) is connected to the control input of the first transistor of the series circuit, this first transistor is a switching transistor (M1) or a high-voltage transistor (HV1') and all other transistors are high-voltage transistors,
and having a capacitive voltage divider circuit connected in parallel with the high-voltage transistors (HV1 to HVn),
wherein said capacitive voltage divider circuit is connected between a reference potential (gnd_ls) of the low side and a reference potential (vdd_hs) of the high side and nodes (X2 to Xn) are arranged between the individual capacitors (C1 to Cn) which are connected to the control terminals of the associated high-voltage transistors (HV2 to HVn), and wherein first diodes (D2 to Dn) are connected in each case between an input-side voltage supply (vdd_ls) of the level shifter (LS) and the control inputs of the high-voltage transistors (HV2 to HVn).

2. The level shifter according to Claim 1, wherein all capacitors (C1 to Cn) have the same capacitance.

3. The level shifter according to Claim 1,
wherein the capacitances of the respective capacitors (C1 to Cn) increase with their sequence number (1 to n).

4. The level shifter according to Claim 1,
wherein in the case of a signal transmission from the low side to the high side, the switching transistor (M1) as well as the high-voltage transistors (HV1 to HVn) are of the n-channel type, a fist resistor (R1) is series-connected before the first transistor (M1 or HV1') and a second resistor (R2) is series-connected after the last high-voltage transistor (HVn).

5. The level shifter according to Claim 1,
wherein in the case of a signal transmission from the high side to the low side, the switching transistor (M1) as well as the high-voltage transistors (HV1 to HVn) are of the p-channel type, a first resistor (R1) is series-connected before the first transistor (M1 or HV1') and a second resistor (R2) is series-connected after the last high-voltage transistor (HVn).

6. The level shifter according to Claim 1,
wherein for the purpose of voltage limiting, Zener diodes (Z2 to Zn) are connected between the control input and source of the associated high-voltage transistors (HV2 to HVn).

7. The level shifter according to Claim 1,
wherein for the purpose of voltage limiting an additional Zener diode (Zn+1) is connected in parallel with the resistor (R2).

8. The level shifter according to Claim 1,
wherein the nodes (X2 to Xn) are each connected by means of second diodes (DD2 to DDn) to associated external terminals of the level shifter (LS).

9. The level shifter according to Claim 1,
wherein the level shifter (LS) is implemented as a monolithically integrated circuit on one substrate or suitably distributed over a plurality of substrates (S1 to Sn).

## Revendications

1. Levelshifter (LS) (modificateur de niveau), pour la transmission unidirectionnelle d'un signal par une première partie de montage avec un premier potentiel à une seconde partie de montage avec un second potentiel,
comprenant un montage en série d'une pluralité de transistors, l'entrée (IN) du levelshifter (LS) étant reliée à l'entrée de commande du premier transistor du montage en série, ce premier transistor étant un transistor de commutation (M1) ou un transistor à haute tension (HV1') et tous les autres transistors des transistors à haute tension,
et un circuit capacitif diviseur de tension monté en parallèle avec les transistors à haute tension (HV1 à HVn),
ce circuit capacitif diviseur de tension étant commuté entre un potentiel de référence (gnd_ls) du low side (côté bas) et un potentiel de référence (vdd_hs) du high side (côté haut) et des noeuds (X2 à Xn) étant disposés entre les différents condensateurs (C1 à Cn), lesquels sont reliés aux branchements de commande des transistors à haute tension (HV2 à HVn) attribués et des premières diodes (D2 à Dn) étant branchées à chaque fois entre une alimentation en tension (vdd_ls) côté entrée du levelshifter (LS) et les entrées de commande des transistors à haute tension (HV2 à HVn).

2. Levelshifter selon la revendication 1,
tous les condensateurs (C1 à Cn) présentant la même capacité.

3. Levelshifter selon la revendication 1,
les capacités des condensateurs respectifs (C1 à Cn) augmentant avec leur nombre ordinal (1 à n).

4. Levelshifter selon la revendication 1,
le transistor de commutation (M1) de même que les transistors à haute tension (HV1 à HVn) étant du type n-canal lors d'une transmission de signal du low side vers le high side, une première résistance (R1) étant branchée en série en amont du premier transistor (M1 ou HV1') et une seconde résistance (R2) étant branchée en série en aval du dernier transistor à haute tension (HVn).

5. Levelshifter selon la revendication 1,
le transistor de commutation (M1) de même que les transistors à haute tension (HV1 à HVn) étant du type p-canal lors d'une transmission de signal du high side au low side, une première résistance (R1) étant montée en série en amont du premier transistor (M1 ou HV1') et une seconde résistance (R2) en série en aval du dernier transistor à haute tension (HVn).

6. Levelshifter selon la revendication 1,
des diodes de Zener (Z2 à Zn) étant raccordées entre l'entrée de commande et la source des transistors à haute tension (HV2 à HVn) associés pour la limitation de tension.

7. Levelshifter selon la revendication 7,
une autre diode de Zener (Zn+1) étant montée parallèlement à la résistance (R2) pour la limitation de tension.

8. Levelshifter selon la revendication 1,
les noeuds (X2 à Xn) étant reliés à chaque fois au moyen de secondes diodes (DD2 à DDn) avec des branchements externes associés du levelshifter (LS).

9. Levelshifter selon la revendication 1,
le levelshifter (LS) étant conçu de façon intégrée et monolithe sur un substrat ou, avec une répartition appropriée, sur une pluralité de substrats (S1 à Sn).
